# EUROPEAN PATENT APPLICATION

(11) **EP 4 541 952 A1**
(43) Date of publication of application: **23.04.2025**
(21) Application number: 23823562.6
(22) Date of filing: 09.05.2023
(51) Int. Cl.: C30B 29/36, C23C 16/24, C30B 25/18, H01L 21/20, H01L 21/205

(54) **METHOD FOR PRODUCING HETEROEPITAXIAL WAFER**

(30) Priority: 14.06.2022 JP 2022095410
(71) Applicant: Shin-Etsu Handotai Co., Ltd., Tokyo 100-0004 (JP)
(72) Inventor: MATSUBARA, Toshiki, Nishishirakawa-gun, Fukushima 961-8061 (JP); SUZUKI, Atsushi, Nishishirakawa-gun, Fukushima 961-8061 (JP); OHTSUKI, Tsuyoshi, Nishishirakawa-gun, Fukushima 961-8061 (JP); ABE, Tatsuo, Nishishirakawa-gun, Fukushima 961-8061 (JP)
(74) Representative: Sonnenhauser, Thomas Martin
(86) International application number: PCT/JP2023/017373
(87) International publication number: WO 2023/243259

(57) **Abstract**

The present invention is a method for producing a heteroepitaxial wafer of hetero-epitaxially growing a 3C-SiC single crystal film on a single crystal silicon substrate. The method includes: with using a reduced-pressure CVD apparatus, a first step of removing a natural oxide film on a surface of the single crystal silicon substrate with hydrogen baking; a second step of forming a SiC nucleus on the single crystal silicon substrate under a condition of a pressure of 13 Pa or higher and 13332 Pa or lower and a temperature of 600°C or higher and 1200°C or lower while a source gas containing carbon is supplied; and a third step of growing a SiC single crystal under a condition of a pressure of 13 Pa or higher and 13332 Pa or lower and a temperature of 800°C or higher and lower than 1200°C while a source gas containing carbon and silicon is supplied to form the 3C-SiC single crystal film. This provides a method for producing a heteroepitaxial wafer that can efficiently epitaxially growing the 3C-SiC single crystal film with good quality on the single crystal silicon substrate.

## Description

### TECHNICAL FIELD

The present invention relates to a method for producing a heteroepitaxial wafer of hetero-epitaxially growing a 3C-SiC single crystal film on a single crystal silicon substrate.

### BACKGROUND ART

SiC has a bandgap of 2.2 to 3.3 eV, which is wider than a bandgap of Si of 1.1 eV, and thus has high dielectric breakdown strength. In addition, SiC has a large thermal conductance, and is therefore a material expected as a semiconductor material for semiconductor devices such as a power device and a high-frequency device.

Use as a platform for gallium nitride (GaN) growth is also in progress (for example, Patent Document 1 and Non Patent Document 1). The SiC wafer mainly has a small diameter, but is required to have a large diameter for the power device and the high-frequency device. Formation of a 3C-SiC single crystal film with good quality on a large-diameter substrate enables to produce a large-diameter heteroepitaxial wafer having a GaN layer with good quality, in addition to use of the 3C-SiC single crystal film itself.

Accordingly, epitaxial growth on a silicon substrate having good consistency with device process, as a method for increasing the diameter, has been investigated (for example, Patent Documents 1 and 2).

These Patent Documents disclose that a 3C-SiC single crystal film can grow on a silicon substrate and that a 3C-SiC single crystal film can grow on a large-diameter substrate, such as a substrate with 300 mm in diameter, by selecting a type of a reactor.

In the formation of the 3C-SiC single crystal film in these Patent Documents, two raw material gases of a gas containing a carbon source precursor and a gas containing a silicon source precursor are introduced into a reactor together with a carrier gas, and these raw material gasses are decomposed to grow the film by a high-temperature treatment (up to 1200°C) or by combination of the high-temperature treatment and a plasma treatment.

When the film is formed by simultaneously flowing two types of the raw material gas as above, it is extremely difficult to grow a 3C-SiC single crystal film with good quality with control of these raw material gasses due to difference in thermal stability and diffusion coefficient of each type of the gas species, and there is a problem of a narrow range of usable process conditions (For example, the growth needs to be performed under a process condition such that it does not occur that the epitaxial growth does not occur and the decomposed raw material gases react in a gas phase to contaminate the reactor.). In addition, there is a problem of deteriorated compatibility with the existing process because the high-temperature treatment is required (The film having a large diameter such as 300 mm is desirably formed at a temperature as low as possible due to a problem such as slip resistance.). Increase in types of the raw material gas used causes a problem of increase in costs of an apparatus and attached equipment, and a safety problem (Specifically, a gas to be a silicon source has typically high reactivity.). Therefore, the number of types of the raw material gas used is preferably small.

As an example of growing the 3C-SiC single crystal film on the silicon substrate, Patent Document 3 discloses use of a single crystal silicon substrate with a plane orientation (110) as the single crystal silicon substrate in order to more reduce lattice mismatch between silicon and SiC. Although the use is advantageous in terms of lattice mismatch, limiting the plane orientation is undesirable when the production of the heteroepitaxial wafer is considered. Patent Document 3 also discloses formation of a 3C-SiC single crystal layer containing hydrogen, but it is imagined that hydrogen is easily eliminated during temperature raising in the epitaxial growth sequence, and a condition independent on the hydrogen amount is desired.

Patent Document 4 mentions an off-angle of the single crystal silicon substrate, but mentioned are carbonization of propane and subsequent growth of propane + silane gas. This growth also increases the number of types of the raw material gas, which is disadvantageous for the epitaxial growth.

Patent Document 5 discloses a method of growing a 3C-SiC single crystal layer on a single crystal silicon substrate with a plane orientation of (111) and a diameter of smaller than 8 inch (200 mm) by using monomethylsilane as a raw material gas. In this time, the film is formed under the following condition: a temperature of the single crystal silicon substrate reaches a film formation condition of 1050 to 1100°C, and then a pressure in a chamber is 2×10⁻⁴ to 3×10⁻⁴ Torr (0.02 to 0.03 Pa) within 5 to 12 hours. In the method, the 3C-SiC single crystal layer is formed under the condition with extremely low pressure, and thus the method has a problem of a low film forming speed.

### CITATION LIST

### PATENT LITERATURE

Patent Document 1: JP 2018-522412 A
Patent Document 2: JP 2021-020819 A
Patent Document 3: JP 2006-253617 A
Patent Document 4: JP 2008-184361 A
Patent Document 5: JP 2017-039622 A

### NON PATENT LITERATURE

Non Patent Document 1: Japanese Journal of Applied Physics 53, 05FL09 (2014)

### SUMMARY OF INVENTION

### TECHNICAL PROBLEM

The present invention has been made to solve the above problem. An object of the present invention is to provide a method for producing a heteroepitaxial wafer that can epitaxially growing a 3C-SiC single crystal film with good quality on a single crystal silicon substrate with good efficiency.

### SOLUTION TO PROBLEM

To achieve the above object, the present invention provides a method for producing a heteroepitaxial wafer of hetero-epitaxially growing a 3C-SiC single crystal film on a single crystal silicon substrate, the method comprising: with using a reduced-pressure CVD apparatus,
a first step of removing a natural oxide film on a surface of the single crystal silicon substrate with hydrogen baking;
a second step of forming a SiC nucleus on the single crystal silicon substrate under a condition of a pressure of 13 Pa or higher and 13332 Pa or lower and a temperature of 600°C or higher and 1200°C or lower while a source gas comprising carbon is supplied into the reduced-pressure CVD apparatus; and
a third step of growing a SiC single crystal under a condition of a pressure of 13 Pa or higher and 13332 Pa or lower and a temperature of 800°C or higher and lower than 1200°C while a source gas comprising carbon and silicon is supplied into the reduced-pressure CVD apparatus to form the 3C-SiC single crystal film.

As above, removing the natural oxide film on the surface of the single crystal silicon substrate in the first step enables formation of a SiC nucleus in the second step.

The combination of the second step of supplying the source gas containing carbon and the third step of supplying the source gas containing carbon and silicon can efficiently produce the target heteroepitaxial wafer having the 3C-SiC single crystal film with good quality.

In the second step, setting the temperature to 600°C or higher can prevent inefficiency of the SiC nucleus formation due to low temperature. Setting the temperature to 1200°C or lower can prevent failure of the SiC nucleus formation on the surface of the single crystal silicon substrate due to proceeding of a reaction between the single crystal silicon substrate and the source gas at high temperature.

Setting the pressure to 13 Pa (0.1 Torr) or higher can prevent inefficiency of the SiC nucleus formation due to low pressure. Setting the pressure to 13332 Pa (100 Torr) or lower can prevent occurrence of secondary or further higher reactions such as a reaction of the reactive species with the source gas in the gas phase, which is efficient.

In the third step, setting the temperature to 800°C or higher can prevent stop of the growth of the SiC single crystal due to low temperature. Setting the temperature to lower than 1200°C can prevent occurrence of slip dislocation.

Setting the pressure of 13 Pa (0.1 Torr) or higher can prevent stop of the SiC single crystal growth due to excessively low pressure. Setting the pressure of 13332 Pa (100 Torr) or lower can prevent occurrence of secondary or further higher reactions such as a reaction of the reactive species with the source gas in the gas phase, which consequently achieves certain epitaxial growth. This setting can prevent poly-crystallization of the 3C-SiC single crystal film.

In this case, methane, ethylene, acetylene, or propane may be used as the source gas comprising carbon.

Moreover, monomethylsilane or trimethylsilane may be used as the source gas comprising carbon and silicon.

In each of the second step and the third step, these source gases (raw material gasses) for use is relatively easily prepared, and SiC nucleus formation and SiC single crystal growth can be performed under the extremely simple condition by using one type of the raw material gas.

Moreover, the first step may be performed under a condition of a temperature of 1000°C or higher and 1200°C or lower.

Setting such a temperature condition can more efficiently remove the natural oxide film on the surface of the single crystal silicon substrate, and can prevent occurrence of slip dislocation.

Moreover, the second step may be performed under a condition of gradually raising a temperature from a range of 600°C or higher and 800°C or lower to a range of 900°C or higher and 1200°C or lower.

Such a setting can more effectively form the SiC nucleus in the second step.

### ADVANTAGEOUS EFFECTS OF INVENTION

The method for producing a heteroepitaxial wafer of the present invention can provide the heteroepitaxial wafer in which the 3C-SiC single crystal film is directly formed on the single crystal silicon substrate by an easy production process with good efficiency.

### BRIEF DESCRIPTION OF DRAWINGS

FIG. 1 is a graph of an example of a growth sequence of the first embodiment;
FIG. 2 is a graph of a result of In plane XRD analysis of 3C-SiC on Si (111) grown in Example 1; and
FIG. 3 is a graph of a result of In plane XRD analysis of 3C-SiC on Si (111) grown in Comparative Example 1.

### DESCRIPTION OF EMBODIMENTS

Hereinafter, the embodiment of the present invention will be described with reference to the drawings, but the present invention is not limited thereto.

As noted above, there has been a demand for the method for producing the heteroepitaxial wafer that can form the 3C-SiC single crystal film on the single crystal silicon substrate. The present inventors have made earnest study, and consequently found that the 3C-SiC single crystal film with high quality can be efficiently formed by combining: with using a reduced-pressure CVD apparatus, hydrogen baking for removing a natural oxide film on a surface of the single crystal silicon substrate (first step); with a predetermined condition for easily forming a SiC nucleus [pressure: 13 Pa or higher and 13332 Pa or lower, temperature: 600°C or higher and 1200°C or lower] while a source gas (containing carbon) is supplied (second step); and a predetermined condition for easily growing a SiC single crystal [pressure: 13 Pa or higher and 13332 Pa or lower, temperature: 800°C or higher and lower than 1200°C] while a source gas (containing carbon and silicon) is supplied (third step). This finding has led to completion of the present invention.

Hereinafter, a specific example of each step will be described.

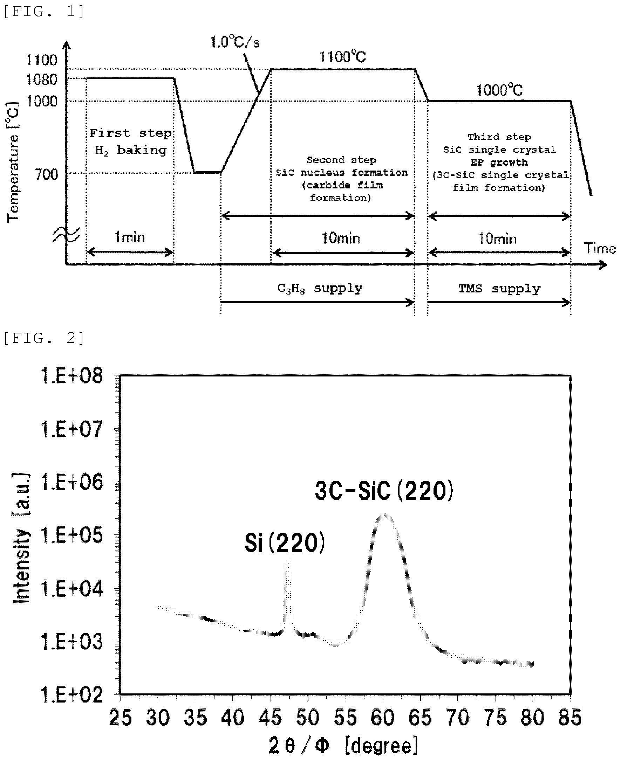

FIG. 1 is a graph of an example of a growth sequence of the embodiment. In the present embodiment, a first step of hydrogen baking (hereinafter, also referred to as "H₂ annealing", a second step being a SiC nucleus formation step, and a third step being a step of growing a SiC single crystal (step of forming a 3C-SiC single crystal film) are sequentially performed. Hereinafter, each step will be described.

### <First Step>

First, a single crystal silicon substrate is arranged in a reduced-pressure CVD apparatus (hereinafter, also referred to as RP-CVD [Reduced Pressure - Chemical Vaper Deposition] apparatus), and hydrogen gas is introduced to remove a natural oxide film on the surface with hydrogen baking (H₂ annealing). If the oxide film remains, SiC nucleus cannot be formed on the single crystal silicon substrate. The H₂ annealing in this time is preferably performed under a condition of, for example, a temperature of 1000°C or higher and 1200°C or lower. Setting the temperature to 1000°C or higher can prevent a long-time treatment for removing a residue of the natural oxide film, which is efficient. Setting the temperature to 1200°C or lower can effectively prevent occurrence of slip dislocation due to high temperature. Note that the pressure and the time in the H₂ annealing in this time is not particularly limited as long as the natural oxide film can be removed.

In the example shown in FIG. 1, the H₂ annealing is performed at 1080°C for 1 minute. The hydrogen gas may be introduced after this first step, or subsequently introduced in the second or third step (carrier gas).

### <Second Step>

Then, the SiC nucleus is formed on the single crystal silicon substrate by setting the predetermined pressure and temperature while a source gas containing carbon is supplied into the RP-CVD apparatus. To form the 3C-SiC nucleus on the surface of the single crystal silicon substrate, for example, a hydrocarbon gas may be used as the source gas. For example, methane, ethylene, acetylene, propane, etc. may be introduced. Such a source gas can be easily prepared, and the one type of the source gas allows the condition of the SiC nucleus formation to be simple.

This SiC nucleus can be formed on the surface of the single crystal silicon substrate at a pressure of 13 Pa or higher and 13332 Pa or lower (0.1 Torr or higher and 100 Torr or lower) and a temperature of 600°C or higher and 1200°C or lower.

In the step of forming the SiC nucleus, a reaction between the single crystal silicon substrate and the raw material gas proceeds under a condition of a temperature higher than 1200°C to fail to form the SiC nucleus on the surface of the single crystal silicon substrate. A case where the temperature is lower than 600°C cannot efficiently form the SiC nucleus due to the excessively low temperature.

Setting the pressure to 13332 Pa (100 Torr) or lower can prevent occurrence of secondary or further higher reactions such as a reaction of the reactive species with the raw material gas in the gas phase, which is efficient. Meanwhile, an excessively low pressure causes the SiC nucleus formation to be inefficient, and therefore a lower limit of the pressure is 13 Pa (0.1 Torr).

Transition of the temperature from the first step to the second step is not particularly limited. For example, the first step is performed at 1080°C as noted above, and then the temperature may be directly regulated from this 1080°C by raising or lowering the temperature to the predetermined temperature retained in the second step.

Alternatively, the first step is performed at 1080°C, and the temperature is lowered once to a temperature range of 600°C or higher and 800°C or lower. Then, as the second step, the temperature may be gradually raised from the temperature within the range of 600°C or higher and 800°C or lower to the temperature within a range of 900°C or higher and 1200°C or lower. In this time, the temperature is raised and then the predetermined temperature after the raising may be retained for, for example, 10 minutes. Such regulation can form the SiC nucleus more effectively.

A temperature-raising rate of raising the temperature from the temperature range of 600°C or higher and 800°C or lower is preferably about 1.0 °C/sec. The temperature-raising rate as above is not excessively high, and can effectively prevent difficulty in control due to divergence between the set temperature during or after the temperature raising and the actual temperature of the substrate. In addition, the temperature-raising rate, which is not excessively low, can effectively inhibit ununiform nucleus formation and tendency of defect formation in the epitaxial growth due to a long passing time through the 3C-SiC nucleus formation temperature region.

In the example shown in FIG. 1, the temperature is lowered to 700°C after the first step, raised to 1100°C at a temperature-raising rate of 1.0 °C/sec, and then retained at 1100°C for 10 minutes as the second step. The pressure is 13332 Pa (100 Torr).

### <Third Step>

The SiC single crystal is grown under a condition of a pressure of 13 Pa or higher and 13332 Pa or lower (0.1 Torr or higher and 100 Torr or lower) and a temperature of 800°C or higher and lower than 1200°C while a source gas containing carbon and silicon is supplied into the RP-CVD apparatus to form the 3C-SiC single crystal film. Such a condition can efficiently grow the SiC single crystal to form the 3C-SiC single crystal film. As the source gas, monomethylsilane or trimethylsilane may be introduced, for example. Such a source gas can be easily prepared, and the one type of the source gas allows the condition of the SiC single crystal growth to be simple.

If the growth pressure is higher than 13332 Pa (100 Torr), the formed 3C-SiC becomes polycrystalline. Meanwhile, the pressure is set to 13332 Pa (100 Torr) or lower in this third step in the present invention, thereby secondary or further higher reactions in the gas phase can be inhibited as noted above, and the 3C-SiC single crystal film can be certainly and efficiently formed. The pressure may be more preferably 1333 Pa (10 Torr) or lower, and further may be 133 Pa (1 Torr) or lower. These conditions form voids directly under the 3C-SiC single crystal film, and yield an effect of relaxing stress in the entirety of the heteroepitaxial layer. Meanwhile, excessively low pressure causes inefficient SiC single crystal growth, and thus a lower limit of the pressure is 13 Pa (0.1 Torr).

The temperature of lower than 800°C stops the growth of the SiC single crystal as noted above, and the temperature of 1200°C or higher can cause slip dislocation. Thus, the temperature is 800°C or higher and lower than 1200°C as noted above.

In the example shown in FIG. 1, the temperature is retained at 1000°C for 10 minutes in the third step. The pressure is 13332 Pa (100 Torr).

The method for producing a heteroepitaxial wafer of the present invention has been described as above. As noted above, the natural oxide film on the surface of the single crystal silicon substrate is removed and then the SiC nucleus is formed. This method can certainly form the SiC nucleus and consequently form the 3C-SiC single crystal film.

In addition, introducing the SiC nucleus formation step before the step of forming the 3C-SiC single crystal film can inhibit deterioration of crystallinity due to lattice mismatch between Si and 3C-SiC, and can form the 3C-SiC single crystal film with good quality.

The aforementioned growth condition allows the heteroepitaxial growth rate to be determined by transportation of the supplying gas, and not limited by a plane orientation of the single crystal silicon substrate. The 3C-SiC single crystal film can be grown without formation of a layer containing hydrogen. Further, the 3C-SiC single crystal film can be formed on a large-diameter single crystal silicon substrate having a diameter of, for example, 300 mm or larger.

The film thickness in this time depends on the pressure and the temperature, and the film formation time is appropriately set based on the set pressure and temperature condition for a target film thickness.

In this case, as for the 3C-SiC single crystal film, a thin film having a thickness of about 4 nm to a thick film having a thickness of several micrometers can be formed, for example.

The 3C-SiC single crystal film grown as above has a flat surface, and therefore the method for producing a heteroepitaxial wafer having a GaN layer with high quality on the 3C-SiC single crystal film can also be provided by further growing GaN on the surface of the 3C-SiC single crystal film. Alternatively, a wafer having a Si layer with high quality on the 3C-SiC single crystal film can be provided by further growing Si on the surface of the 3C-SiC single crystal film.

### EXAMPLE

Hereinafter, the present invention will be more specifically described with showing Examples and Comparative Examples of the present invention, but the present invention is not limited thereto.

### (Example 1)

A boron-doped single crystal silicon substrate having a diameter of 300 mm, plane orientation (111), and a high resistivity (1000 Ω·cm) was prepared, the wafer was arranged on a susceptor in a reaction furnace in a RP-CVD apparatus, and H₂ annealing was performed at 1080°C for 1 minute (the first step).

Subsequently, the temperature in the furnace was lowered to 700°C, then propane gas was introduced while the temperature was raised to 1100°C at a temperature-raising rate of 1 °C/sec, and the temperature reached 1100°C was retained for 10 minutes to form a 3C-SiC nucleus (the second step).

After the nucleus formation step, the temperature in the furnace was lowered to 1000°C, then trimethylsilane gas was introduced, and a 3C-SiC single crystal film was formed (the third step).

The growth pressure was constantly set to 13 Pa or 13332 Pa (0.1 Torr or 100 Torr).

As a result of the growth for 10 minutes, the film thicknesses of the resultants in the pressure patterns were 80 nm and 115 nm, respectively.

After the film formation, an X-ray diffraction (XRD) spectrum with In plane arrangement was observed, and a peak of 3C-SiC (220) parallel to Si (220) was confirmed as shown in the graph of the XRD analysis result in FIG. 2 even any of the growth pressure conditions. It was confirmed that the single crystal 3C-SiC film grew.

### (Comparative Example 1)

A single crystal silicon substrate similar to that in Example 1 was prepared, the wafer was arranged on a susceptor in a reaction furnace in a RP-CVD apparatus, and H₂ annealing was performed at 1080°C for 1 minute (the first step).

The subsequent second step (the step for forming the 3C-SiC nucleus) was not performed. The temperature in the furnace set to 1000°C, and trimethylsilane gas was introduced and retained for 10 minutes to form a 3C-SiC single crystal film (the third step).

The growth pressure was set to 13332 Pa (100 Torr).

As a result, the film thickness was 45 nm.

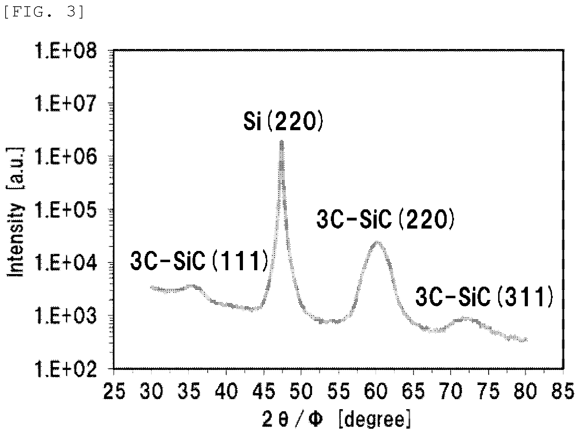

An XRD spectrum with In plane arrangement was observed, peaks of 3C-SiC (111) and 3C-SiC (311) were observed in addition to the peak of 3C-SiC (220) parallel to Si (220) as shown in the graph of the XRD analysis result in FIG. 3, and it was confirmed that a polycrystalline 3C-SiC film grew.

### (Example 2)

A single crystal silicon substrate similar to that in Example 1 was prepared, the wafer was arranged on a susceptor in a reaction furnace in a RP-CVD apparatus, and H₂ annealing was performed at 1080°C for 1 minute (the first step).

Subsequently, the temperature in the furnace was set to 600°C, propane gas was introduced, and the temperature was retained for 10 minutes to form a 3C-SiC nucleus (the second step).

Thereafter, the temperature in the furnace was lowered to 800°C, then trimethylsilane gas was introduced, and retained for 10 minutes to form a 3C-SiC single crystal film (the third step).

The growth pressure was constantly set to 13 Pa or 13332 Pa (0.1 Torr or 100 Torr).

As a result, the film thicknesses of the resultants in the pressure patterns were 60 nm and 92 nm, respectively.

An XRD spectrum with In plane arrangement was observed, a peak of 3C-SiC (220) parallel to Si (220) was confirmed, and it was confirmed that the single crystal 3C-SiC film grew.

### (Example 3)

A 3C-SiC single crystal film was grown under the same condition as in Example 2 except that the temperatures in the second step and the third step were respectively set to 1200°C and 1190°C (at the growth pressure of constantly 13 Pa (0.1 Torr) and 13332 Pa (100 Torr)).

As a result, the film thicknesses of the resultants in the pressure patterns were 90 nm and 120 nm, respectively.

An XRD spectrum with In plane arrangement was observed, and a peak of 3C-SiC (220) parallel to Si (220) was confirmed. It was confirmed that the single crystal 3C-SiC film grew.

### (Comparative Example 2)

A 3C-SiC single crystal film was grown under the same condition of the growth temperature of 13332 Pa (100 Torr) in Example 2 except that the temperature in the second step was set to 500°C.

Separately, a 3C-SiC single crystal film was grown under the same condition of the growth temperature of 13332 Pa (100 Torr) in Example 2 except that the temperature in the second step was set to 1250°C.

As a result, the film thicknesses of the resultants in the temperature patterns in the second step were 38 nm and 43 nm, respectively.

The film thicknesses formed as above were extremely small compared with Example 2, and the efficiency were considerably bad. This is presumably because the SiC nucleus was not sufficiently formed due to the extremely low or high temperature in the second step, and thereby almost no epitaxial growth proceeded in the third step.

### (Comparative Example 3)

A 3C-SiC single crystal film was grown under the same condition of the growth temperature of 13332 Pa (100 Torr) in Example 2 except that the temperature in the third step was set to 700°C.

Separately, a 3C-SiC single crystal film was grown under the same condition of the growth temperature of 13332 Pa (100 Torr) in Example 2 except that the temperature in the third step was set to 1250°C.

As a result, the film thicknesses of the resultants in the temperature patterns in the third step were 40 nm and 130 nm, respectively.

The film thickness formed at 700°C as above was extremely small compared with Example 2, and the efficiency was considerably bad. The case of 1250°C caused slip dislocation.

### (Comparative Example 4)

A 3C-SiC single crystal film was grown under the same condition as in Example 2 except that the growth pressure in the second step and the third step was constantly set to 1.3 Pa (0.01 Torr).

As a result, the film thickness was 18 nm.

The film thickness formed at a growth pressure of 1.3 Pa (0.01 Torr) as above was extremely small compared with Example 2, and the efficiency was considerably bad.

### (Comparative Example 5)

A 3C-SiC single crystal film was grown under the same condition as in Example 2 except that the growth pressure in the second step and the third step was constantly set to 19998 Pa (150 Torr).

As a result, the film thickness was 98 nm.

An XRD spectrum with In plane arrangement was observed, and peaks of 3C-SiC (111) and 3C-SiC (311) were observed in addition to the peak of 3C-SiC (220) parallel to Si (220). It was confirmed that a polycrystalline 3C-SiC film was grown.

This description encompasses the following aspects.
[1]: A method for producing a heteroepitaxial wafer of hetero-epitaxially growing a 3C-SiC single crystal film on a single crystal silicon substrate, the method comprising: with using a reduced-pressure CVD apparatus,
   a first step of removing a natural oxide film on a surface of the single crystal silicon substrate with hydrogen baking;
   a second step of forming a SiC nucleus on the single crystal silicon substrate under a condition of a pressure of 13 Pa or higher and 13332 Pa or lower and a temperature of 600°C or higher and 1200°C or lower while a source gas comprising carbon is supplied into the reduced-pressure CVD apparatus; and
   a third step of growing a SiC single crystal under a condition of a pressure of 13 Pa or higher and 13332 Pa or lower and a temperature of 800°C or higher and lower than 1200°C while a source gas comprising carbon and silicon is supplied into the reduced-pressure CVD apparatus to form the 3C-SiC single crystal film.
[2]: The method for producing a heteroepitaxial wafer according to [1] described above, wherein methane, ethylene, acetylene, or propane is used as the source gas comprising carbon.
[3]: The method for producing a heteroepitaxial wafer according to [1] or [2] described above, wherein monomethylsilane or trimethylsilane is used as the source gas comprising carbon and silicon.
[4]: The method for producing a heteroepitaxial wafer according to any one of [1] to [3] described above, wherein the first step is performed under a condition of a temperature of 1000°C or higher and 1200°C or lower.
[5]: The method for producing a heteroepitaxial wafer according to any one of [1] to [4] described above,
wherein the second step is performed under a condition of gradually raising a temperature from a range of 600°C or higher and 800°C or lower to a range of 900°C or higher and 1200°C or lower.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A method for producing a heteroepitaxial wafer of hetero-epitaxially growing a 3C-SiC single crystal film on a single crystal silicon substrate, the method comprising: with using a reduced-pressure CVD apparatus,
a first step of removing a natural oxide film on a surface of the single crystal silicon substrate with hydrogen baking;
a second step of forming a SiC nucleus on the single crystal silicon substrate under a condition of a pressure of 13 Pa or higher and 13332 Pa or lower and a temperature of 600°C or higher and 1200°C or lower while a source gas comprising carbon is supplied into the reduced-pressure CVD apparatus; and
a third step of growing a SiC single crystal under a condition of a pressure of 13 Pa or higher and 13332 Pa or lower and a temperature of 800°C or higher and lower than 1200°C while a source gas comprising carbon and silicon is supplied into the reduced-pressure CVD apparatus to form the 3C-SiC single crystal film.

2. The method for producing a heteroepitaxial wafer according to claim 1, wherein methane, ethylene, acetylene, or propane is used as the source gas comprising carbon.

3. The method for producing a heteroepitaxial wafer according to claim 1, wherein monomethylsilane or trimethylsilane is used as the source gas comprising carbon and silicon.

4. The method for producing a heteroepitaxial wafer according to claim 2, wherein monomethylsilane or trimethylsilane is used as the source gas comprising carbon and silicon.

5. The method for producing a heteroepitaxial wafer according to any one of claims 1 to 4, wherein the first step is performed under a condition of a temperature of 1000°C or higher and 1200°C or lower.

6. The method for producing a heteroepitaxial wafer according to any one of claims 1 to 4, wherein the second step is performed under a condition of gradually raising a temperature from a range of 600°C or higher and 800°C or lower to a range of 900°C or higher and 1200°C or lower.

7. The method for producing a heteroepitaxial wafer according to claim 5, wherein the second step is performed under a condition of gradually raising a temperature from a range of 600°C or higher and 800°C or lower to a range of 900°C or higher and 1200°C or lower.
